# EUROPEAN PATENT SPECIFICATION

(11) **EP 4 665 796 B1**
(45) Date of publication and mention of the grant of the patent: **26.08.2026**
(21) Application number: 23706558.6
(22) Date of filing: 16.02.2023
(51) Int. Cl.: C08L 83/04

(54) **CURABLE POLYSILOXANE COMPOSITION AND ENCAPSULANT INCLUDING THE SAME**
HÄRTBARE POLYSILOXANZUSAMMENSETZUNG UND VERKAPSELUNGSSTOFF DAMIT
COMPOSITION DE POLYSILOXANE DURCISSABLE ET ENCAPSULANT LA COMPRENANT

(43) Date of publication of application: 24.12.2025
(73) Proprietor: Wacker Chemie AG, 81671 München (DE)
(72) Inventor: KWON, Ah Hyun, Seongnam-si Gyeonggi-do 13494 (KR); JOO, YoungHyuk, Seongnam-si Gyeonggi-do 13494 (KR); LEE, Ji Won, Seongnam-si Gyeonggi-do 13494 (KR); SONG, Myung Suk, Seongnam-si Gyeonggi-do 13494 (KR); SONG, Sun Sik, Seongnam-si Gyeonggi-do 13494 (KR)
(74) Representative: Mieskes, Klaus Theoderich
(86) International application number: PCT/EP2023/053939
(87) International publication number: WO 2024/170087

(56) References cited:
- EP-B1- 2 303 965
- JP-B2- 6 633 846

## Description

### [Technical Field]

The present invention relates to a curable polysiloxane composition and an encapsulant including the same.

### [Background Art]

Light-emitting diode (LED) is one of the next-generation display technologies. Recently, as the size of LED device is decreasing, a technology capable of protecting the LED device and implementing high light transmittance for the LED device is required. Accordingly, a silicon material is attracting attention as an encapsulant material for LED devices because of the excellent thermal stability and light stability thereof.

However, an encapsulant made of a silicon material does not meet a high transmittance needed to smoothly emit light from each light source and, due to the intrusion of corrosive gas or water vapor, the encapsulant suffers from degradation of mechanical properties, thus being peeled off. As a result, the effect of an encapsulant is reduced.

Therefore, research on a silicon material capable of improving the effect as an encapsulant for LED devices without deterioration in mechanical properties while exhibiting high transmittance is required.

EP2303965 B1 discloses a polyorganosiloxane composition for a semiconductor device coating based on a hydrosilylation curing system. Its practical examples 1-3 comprise a branched-chain phenyl-T vinyl-M organopolysiloxane, a branched-chain phenyl-T hydrido-M organopolysiloxane and a platinum divinyl tetramethyl disiloxane catalyst.

JP6633846 B2 discloses an encapsulant composition for semiconductor devices comprising a branched, phenyl- and vinyl-functional organopolysiloxane, a branched phenyl- and hydrido-functional organopolysiloxane, an isocyanurate compound and a platinum hydrosilylation catalyst.

### [Disclosure]

### [Technical Problem]

Therefore, the present invention has been made in view of the above problems, and it is one object of the present invention to provide a curable polysiloxane composition having excellent transparency, high transmittance and mechanical properties and an encapsulant including the curable polysiloxane.

### [Technical Solution]

In accordance with an aspect of the present invention, the above and other objects can be accomplished by the provision of a curable polysiloxane composition, including: (A) a branched polysiloxane compound having at least one Si-bonded alkenyl group and at least one Si-bonded aryl group per molecule and including a siloxane unit represented by R SiO_{3/2} (where R' is a substituted or unsubstituted monovalent hydrocarbon group); (B) a branched polysiloxane compound having at least one Si-bonded hydrogen and at least one Si-bonded aryl group per molecule and including a siloxane unit represented by R"SiO_{3/2} (where R" is a substituted or unsubstituted monovalent hydrocarbon group) and as further defined below; (C) a compound that promotes a reaction between the alkenyl group of the compound (A) and the hydrogen of the compound (B); and (D) an inorganic filler.

In an embodiment of the present invention, the compound (A) may be represented by Average Unit Formula 3 below:

[Average Unit Formula 1] (R¹R²R³SiO_{1/2})ₐ (R⁴R⁵SiO_{2/2})_{b} (R⁶SiO_{3/2})_{c} (SiO_{4/2})_{d}

where R¹, R² and R³ are each independently selected from a substituted or unsubstituted monovalent hydrocarbon group, at least one of R¹, R² and R³ is an alkenyl group, R⁴ and R⁵ are each independently selected from a substituted or unsubstituted monovalent hydrocarbon group and an aryl group having 6 to 12 carbon atoms, R⁶ is an aryl group having 6 to 12 carbon atoms, 0 < a < 1, 0 < b < 1, 0 < c < 1, 0 ≤ d < 1, and a + b + c + d = 1.

The compound (B) is represented by Average Unit Formula 2 below:

[Average Unit Formula 2] (R⁷R⁸R⁹SiO_{1/2})ₑ (R¹⁰SiO_{3/2})_{f} (R¹¹SiO_{3/2})_{g}

where R⁷, R⁸ and R⁹ are each independently selected from a substituted or unsubstituted monovalent hydrocarbon group, at least one of R⁷, R⁸ and R⁹ is hydrogen, R¹⁰ is a substituted or unsubstituted monovalent hydrocarbon group, R¹¹ is an aryl group having 6 to 12 carbon atoms, 0 < e < 1, 0 ≤ f < 1, 0 < g < 1, and e + f + g = 1.

In an embodiment of the present invention, the compound (C) may include at least one of compounds represented by Chemical Formulas 1 and 2 below: 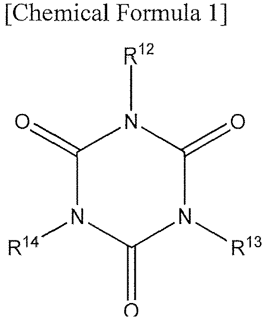 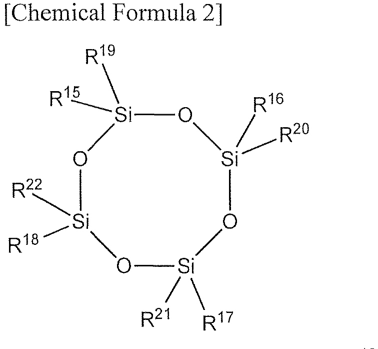 wherein, in Chemical Formula 1, R¹², R¹³ and R¹⁴ are each independently an alkenyl group having 2 to 20 carbon atoms, and in Chemical Formula 2, R¹⁵, R¹⁶, R¹⁷ and R¹⁸ are each independently a substituted or unsubstituted monovalent hydrocarbon group, and R¹⁹, R²⁰, R²¹ and R²² are each independently an alkenyl group having 2 to 20 carbon atoms.

In an embodiment of the present invention, the inorganic filler (D) may be included in an amount of 0.1 parts by weight to 20 parts by weight with respect to 100 parts by weight of the curable polysiloxane composition.

In an embodiment of the present invention, the inorganic filler (D) may include fumed silica.

In an embodiment of the present invention, the fumed silica may include a first fumed silica having a methanol value of less than 15 and a second fumed silica having a methanol value of greater than 40.

In an embodiment of the present invention, the curable polysiloxane composition may have a refractive index of 1.45 to 1.55 at a wavelength of 480 nm and a wavelength of 598 nm.

In an embodiment of the present invention, a cured product with a thickness of 1 mm made of the curability polysiloxane composition may have a light transmittance of 80% or more.

In an embodiment of the present invention, the cured product with a thickness of 1 mm made of the curable polysiloxane composition may have a Shore D hardness of 20 to 40.

In accordance with another aspect of the present invention, there is provided an encapsulant including a curable polysiloxane composition, the curable polysiloxane composition including: (A) a branched polysiloxane compound having at least one Si-bonded alkenyl group and at least one Si-bonded aryl group per molecule and including a siloxane unit represented by R SiO_{3/2} (where R' is a substituted or unsubstituted monovalent hydrocarbon group); (B) a branched polysiloxane compound having at least one Si-bonded hydrogen and at least one Si-bonded aryl group per molecule and including a siloxane unit represented by R"SiO_{3/2} (where R" is a substituted or unsubstituted monovalent hydrocarbon group) and as further defined below; (C) a compound that promotes a reaction between the alkenyl group of the compound (A) and the hydrogen of the compound (B); and (D) an inorganic filler.

### [Advantageous effects]

Since a curable polysiloxane composition according to the present invention includes an inorganic filler, workability and mechanical properties can be improved.

In addition, since the curable polysiloxane composition according to the present invention includes a branched polysiloxane compound having an alkenyl group and an aryl group and a branched polysiloxane compound having a hydrogen and an aryl group and includes a compound capable of forming a silicon-carbon bond by a hydrosilylation reaction, the adhesiveness and transparency of a cured product made of the curable polysiloxane composition can be improved while securing the mechanical properties of the cured product, and the cured product can exhibit a high refractive index, thus having improved light transmittance.

### [Best Mode]

Structural or functional descriptions of embodiments disclosed in the present specification or application are merely illustrated for the purpose of explaining embodiments according to the technical idea of the present invention, embodiments according to the technical idea of the present invention may be implemented in various forms other than the embodiments disclosed in the present specification or application, and it is not to be construed that the technical idea of the present invention is limited to the embodiments described in the present specification or application.

In the present specification or application, when a certain component is "included", this indicates that only the component is included or the component may further include another component unless there is no different disclosure. In addition, it should be understood that all numerical ranges representing physical property values, dimensions, etc. of components described in the present specification or application are modified by the term 'about' in all cases unless otherwise specified.

In addition, the meaning of each term described in the present specification or application is as follows.

Siloxane: a compound having a Si-O-Si bond.

Polysiloxane: a compound having a plurality of Si-O-Si bonds.

Polysiloxane composition: a composition composed of only a polysiloxane compound, or a composition including polysiloxane and mixed with additional compounds for implementing specific performance.

Straight-chain polysiloxane: a polysiloxane having a structure in which a siloxane chain is not connected by interposing an atom linking group onto a Si atom of the main chain (-Si-O-Si-O-) of polysiloxane.

Branched polysiloxane: a polysiloxane containing at least one T-shaped or cross-shaped branch point.

Organopolysiloxane: a polysiloxane having a structure in which an organic group is bonded to a Si atom constituting a Si-O-Si bond.

### <Curable polysiloxane composition>

A curable polysiloxane composition according to the present invention includes (A) a branched polysiloxane compound having at least one Si-bonded alkenyl group and at least one Si-bonded aryl group per molecule and including a siloxane unit represented by R SiO_{3/2} (where R' is a substituted or unsubstituted monovalent hydrocarbon group), (B) a branched polysiloxane compound having at least one Si-bonded hydrogen and at least one Si-bonded aryl group per molecule and including a siloxane unit represented by R SiO_{3/2} (where R" is a substituted or unsubstituted monovalent hydrocarbon group), (C) a compound that promotes a reaction between the alkenyl group of the compound (A) and the hydrogen of the compound (B), and (D) an inorganic filler.

### Component (A)

The curable polysiloxane composition according to the present invention includes (A) a branched polysiloxane compound having at least one Si-bonded alkenyl group and at least one Si-bonded aryl group per molecule and including a siloxane unit represented by R SiO_{3/2} (where R' is a substituted or unsubstituted monovalent hydrocarbon group)

The component (A) may impart strength and refractive index increase to a cured product obtained by curing the curable polysiloxane composition. Specifically, when the curable polysiloxane composition includes the component (A), thermal shock resistance of the cured product may be improved, and a refractive index thereof may be increased so that light transmittance may be improved.

The component (A) includes a branched polysiloxane compound having -Si-O-Si-O-(polysiloxane) as a main chain and including at least one T-shaped or cross-shaped branch point per molecule. Preferably, the component (A) may include only the branched polysiloxane compound, but may exclude a straight-chain polysiloxane compound having a structure in which a siloxane chain is not connected by interposing an atom linking group onto a Si atom of the main chain (-Si-O-Si-O-) of polysiloxane. Since the component (A) excludes the straight-chain polysiloxane compound, a cured product made of the curable polysiloxane compound may have improved transparency, and improved light transmittance due to increased refractive index.

In the component (A), the alkenyl group may be vinyl, allyl, methallyl, butenyl, pentenyl, or hexenyl. Preferably, the alkenyl group may be vinyl.

In the component (A), the aryl group may be phenyl, naphthyl, anthryl, phenanthryl, indenyl, benzophenyl, fluorenyl, xanthenyl, anthronyl, aryloxyaryl, o--phenoxy-phenyl, p-phenoxy-phenyl, an alkaryl group, o-tolyl, m-tolyl, p-tolyl, xylyl, ethylphenyl, aralkyl, benzyl, α-phenylethyl, or β-phenylethyl. Preferably, the aryl group may be phenyl.

In the component (A), a Si-bonded organic group, other than the alkenyl group and the aryl group, may be a substituted or unsubstituted monovalent hydrocarbon group, specifically may be methyl, ethyl, propyl, butyl, pentyl, hexyl, heptyl, or halogenated alkyl. Preferably, the Si-bonded organic group may be methyl.

In the component (A), the siloxane unit represented by R SiO_{3/2} may mean a branched polysiloxane compound having a T-shaped or cross-shaped branch point. R' is a substituted or unsubstituted monovalent hydrocarbon group. A substituent of the monovalent hydrocarbon group may be alkyl, alkenyl, aryl, aralkyl, or halogenated alkyl.

The component (A) may be represented by Average Unit Formula 3 below:

[Average Unit Formula 1] (R¹R²R³SiO_{1/2})ₐ (R⁴R⁵SiO_{2/2})_{b} (R⁶SiO_{3/2})_{c} (SiO_{4/2})_{d}

In Average Unit Formula 1, R¹, R² and R³ are each independently selected from a substituted or unsubstituted monovalent hydrocarbon group, at least one of at least one of R¹, R² and R³ is an alkenyl group, R⁴ and R⁵ are each independently selected from a substituted or unsubstituted monovalent hydrocarbon group and an aryl group having 6 to 12 carbon atoms, R⁶ is an aryl group having 6 to 12 carbon atoms, 0 < a < 1, 0 < b < 1, 0 < c < 1, 0 ≤ d < 1, and a + b + c + d = 1.

A substituent of the monovalent hydrocarbon group may be alkyl, alkenyl, aryl, aralkyl, or halogenated alkyl.

The alkenyl group may be vinyl, allyl, methallyl, butenyl, pentenyl, or hexenyl.

The aryl group having 6 to 12 carbon atoms may be phenyl or naphthyl.
a may be 0 < a < 1, 0 < a < 0.8, 0 < a < 0.5, 0 < a < 0.3, or 0 < a < 0.2.
b may be 0 < b < 1, 0.1 < b < 1, 0.1 < b < 0.9, 0.2 < b < 0.8, or 0.3 < b < 0.7.
c may be 0 < c < 1, 0 < c < 0.8, 0 < c < 0.5, 0.1 < c < 0.5, or 0.2 < c < 0.5.
d may be 0 ≤ d < 1, 0 ≤ d < 0.5, 0 ≤ d < 0.3, 0 ≤ d < 0.2, or 0 ≤ d < 0.1.

Base on the total amount of R¹, R², R³, R⁴, R⁵ and R⁶, the content of the alkenyl group may be 0.1 mol% to 35 mol%, 1 mol% to 35 mol%, 3 mol% to 35 mol%, 3 mol% to 30 mol%, or 5 mol% to 35 mol%. Within these ranges, curability and reactivity of a curable polysiloxane composition may be further improved.

Base on the total amount of R¹, R², R³, R⁴, R⁵ and R⁶, the content of the aryl group may be 10 mol% to 90 mol%, 20 mol% to 90 mol%, 30 mol% to 90 mol%, 30 mol% to 80 mol%, or 40 mol% to 70 mol%. Within these ranges, phenomena, such as light refraction, reflection, and scattering, of a cured product made of the curable polysiloxane composition may be reduced so that transparency and transmittance thereof may be further improved.

The component (A) may exist in a liquid or solid state at 25°C.

Based on the total weight of the curable polysiloxane composition, the content of the component (A) may be 20 % by weight to 90 % by weight, 30 % by weight to 90 % by weight, 35 % by weight to 90 % by weight, 40 % by weight to 90 % by weight, or 45 % by weight to 60 % by weight.

### Component (B)

The curable polysiloxane composition according to the present invention includes (B) a branched polysiloxane compound having at least one Si-bonded hydrogen and at least one Si-bonded aryl group per molecule and including a siloxane unit represented by R SiO_{3/2} (where R" is a substituted or unsubstituted monovalent hydrocarbon group).

The component (B) may be used as a curing agent of the curable polysiloxane composition. Specifically, when the curable polysiloxane composition includes the component (B), a curing reaction with the component (A) by hydrosilylation may proceed efficiently.

The component (B) has -Si-O-Si-O-(polysiloxane) as a main chain and includes a branched polysiloxane compound including at least one T-shaped or cross-shaped branch point per molecule. Preferably, the component (B) may include only the branched polysiloxane compound, but may exclude a straight-chain polysiloxane compound having a structure in which a siloxane chain is not connected by interposing an atom linking group onto a Si atom of the main chain (-Si-O-Si-O-) of polysiloxane. Since the component (B) excludes a straight-chain polysiloxane compound, a cured product made of the curable polysiloxane compound may have improved mechanical properties and transparency.

In the component (B), the aryl group may be phenyl, naphthyl, anthryl, phenanthryl, indenyl, benzophenyl, fluorenyl, xanthenyl, anthronyl, aryloxyaryl, o--phenoxy-phenyl, p-phenoxy-phenyl, an alkaryl group, o-tolyl, m-tolyl, p-tolyl, xylyl, ethylphenyl, aralkyl, benzyl, α-phenylethyl, or β-phenylethyl. Preferably, the aryl group may be phenyl.

In the component (B), a Si-bonded organic group, other than the hydrogen and the aryl group, may be a substituted or unsubstituted monovalent hydrocarbon group, and specifically may be methyl, ethyl, propyl, butyl, pentyl, hexyl, heptyl, or halogenated alkyl. Preferably, the Si-bonded organic group may be methyl.

In the component (B), the siloxane unit represented by R SiO_{3/2} may mean a branched polysiloxane compound having a T-shaped or cross-shaped branch point. R' is a substituted or unsubstituted monovalent hydrocarbon group. A substituent of the monovalent hydrocarbon group may be alkyl, alkenyl, aryl, aralkyl, or halogenated alkyl.

The component (B) is represented by Average Unit Formula 2 below:

[Average Unit Formula 2] (R⁷R⁸R⁹SiO_{1/2})ₑ (R¹⁰SiO_{3/2})_{f} (R¹¹SiO_{3/2})_{g}

In Average Unit Formula 2, R⁷, R⁸ and R⁹ are each independently selected from a substituted or unsubstituted monovalent hydrocarbon group, at least one of at least one of R⁷, R⁸ and R⁹ is hydrogen, R¹⁰ is a substituted or unsubstituted monovalent hydrocarbon group, R¹¹ is an aryl group having 6 to 12 carbon atoms, 0 < e < 1, 0 ≤ f < 1, 0 < g < 1, and e + f + g = 1.

A substituent of the monovalent hydrocarbon group may be alkyl, alkenyl, aryl, aralkyl, or halogenated alkyl.

The aryl group having 6 to 12 carbon atoms may be phenyl or naphthyl.
e may be 0 < e < 1, 0 < e < 0.8, 0.1 < e < 0.8, 0.2 < e < 0.7, or 0.2 < e < 0.6.
f may be 0 ≤ f < 1, 0 ≤ f < 0.8, 0 ≤ f < 0.7, 0 ≤ f < 0.6, or 0 ≤ f < 0.5.
g may be 0 < g < 1, 0 < g < 0.9, 0.1 < g < 0.9, 0.1 < g < 0.8, or 0.2 < g < 0.8.

Based on the total amount of R⁷, R⁸, R⁹, R¹⁰, and R¹¹, the content of the hydrogen may be 0.1 mol% to 40 mol%, 1 mol% to 40 mol%, 3 mol% to 40 mol%, 3 mol% to 40 mol%, or 5 mol% to 40 mol%. Within these ranges, a curing reaction with the component (A) by hydrosilylation may further efficiently proceed.

Based on the total amount of R⁷, R⁸, R⁹, R¹⁰, and R¹¹, the content of the aryl group may be 10 mol% to 90 mol%, 20 mol% to 90 mol%, 30 mol% to 90 mol%, 30 mol% to 80 mol%, or 40 mol% to 70 mol%. Within these ranges, phenomena, such as light refraction, reflection, and scattering, of a cured product made of the curable polysiloxane composition may be reduced so that transparency and transmittance thereof may be further improved.

Based on the total weight of the curable polysiloxane composition, the content of the component (B) is 10 % by weight to 50 % by weight, or 20 % by weight to 50 % by weight.

A molar ratio of the Si-bonded hydrogen in the component (B) to the Si-bonded alkenyl group in the component (A) is 0.7 to 1.0. Within this range, the content of a silicon hydride residue may be reduced, and adhesiveness of a cured product made of the curable polysiloxane composition may be improved.

### Component (C)

The curable polysiloxane composition according to the present invention includes (C) a compound that promotes a reaction between the alkenyl group of the compound (A) and the hydrogen of the compound (B).

The component (C) may increase hardness of a cured product made of the curable polysiloxane composition without changing the content of the branched polysiloxane compound in the components (A) and (B). In addition, the component (C) may improve a refractive index without changing the content of the branched polysiloxane compound in the components (A) and (B) a cured product made of the curable polysiloxane composition.

The component (C) may be combined with a catalyst that promotes the reaction (hydrosilylation reaction) between the alkenyl group of the compound (A) and the hydrogen of the compound (B) to form a complex compound.

The catalyst may include a platinum catalyst, a rhodium catalyst, or a palladium catalyst.

The complex compound may be a platinum/alkenylsiloxane complex compound, a platinum/olefin complex compound, or a platinum/carbonyl complex compound.

The component (C) may include at least one of compounds represented by Chemical Formulas 1 and 2 below:

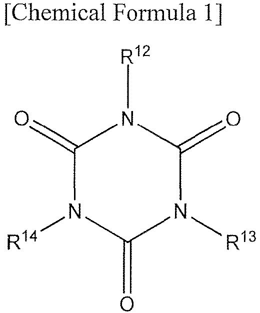

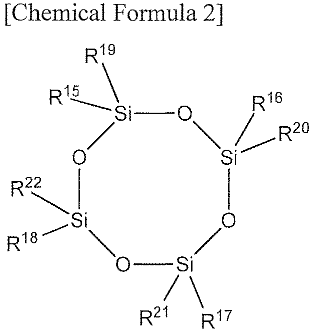

In Chemical Formula 1, R¹², R¹³ and R¹⁴ are each independently an alkenyl group having 2 to 20 carbon atoms. In Chemical Formula 2, R¹⁵, R¹⁶, R¹⁷ and R¹⁸ are each independently a substituted or unsubstituted monovalent hydrocarbon group, and R¹⁹, R²⁰, R²¹ and R²² are each independently an alkenyl group having 2 to 20 carbon atoms.

The compound represented by Chemical Formula 1 may be a compound represented by Chemical Formula 1-1 below:

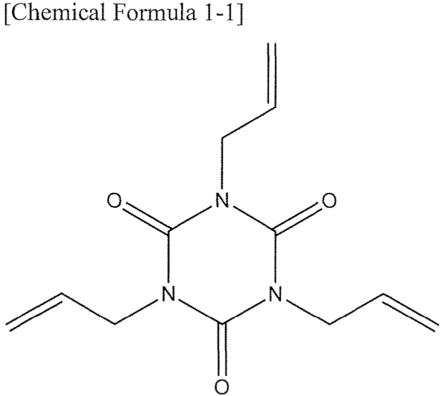

The compound represented by Chemical Formula 2 may be a compound represented by Chemical Formula 2-1 below:

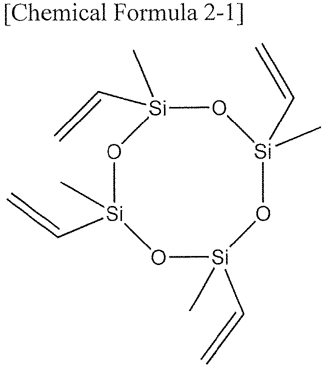

Based on the total weight of the curable polysiloxane composition, the content of the component (C) may be 1 % by weight to 30 % by weight, 1 % by weight to 25 % by weight, 1 % by weight to 20 % by weight, 1 % by weight to 18 % by weight, or 1 % by weight to 15 % by weight.

Based on the total weight of the curable polysiloxane composition, the content of the catalyst may be 0.1 ppm to 10 ppm, 0.1 ppm to 8 ppm, 0.1 ppm to 7 ppm, 1 ppm to 7 ppm, or 1 ppm to 5 ppm.

### Component (D)

The curable polysiloxane composition according to the present invention includes (D) an inorganic filler

The component (D) may improve workability and mechanical properties of a cured product made of the curable polysiloxane composition.

The inorganic filler may include inorganic oxide particles such as silica, barium titanate, titanium oxide, zirconium oxide, niobium oxide, aluminum oxide, cerium oxide, or yttrium oxide, nitride particles such as silicon nitride, boron nitride, silicon carbide, or aluminum nitride, carbon compound particles, or diamond particles.

The inorganic filler may include fumed silica.

The fumed silica is a commercial product or may be prepared by a standard chemical process. The fumed silica may be prepared by hydrolysis or oxidation of volatile chlorosilanes in a hydrogen/oxygen gas flame.

The fumed silica may include a first fumed silica having a methanol value of less than 15 and a second fumed silica having a methanol value of greater than 40 Preferably, a methanol value of the first fumed silica may be 0, and a methanol value of the second fumed silica may be greater than 50.

The methanol value may refer to a percentage (% by weight) of methanol in a water/methanol mixture, which sinks into a liquid, under the conditions of 25°C and 1013 hPa in a state in which about 50% of the fumed silica is wet.

The methanol value may be determined by the following method. An equal volume of each fumed silica is added to a water/methanol mixture under conditions of 25°C and 1013 hPa. Next, after mixing for 5 minutes, the mixture is aged for 10 minutes. Next, the amount of silica precipitated in the mixture is determined. If the fumed silica is not precipitated in the mixture when observed with the naked eye, this experiment is repeated.

The first fumed silica may mean relatively hydrophilic silica, and the second fumed silica may mean relatively hydrophobic silica. Since the component (D) includes both hydrophilic silica and hydrophobic silica, the hardness of the curable polysiloxane composition may be increased so that mechanical properties, thermal shock resistance, formability and workability may be improved.

With respect to 100 parts by weight of the curable polysiloxane composition, the content of the component (D) may be 0.1 parts by weight to 20 parts by weight, 1 part by weight to 20 parts by weight, 1 part by weight to 18 parts by weight, or 3 parts by weight to 10 parts by weight Within these ranges, mechanical properties may be improved without deterioration in transparency and light transmittance.

### Other additives

As needed, the curable polysiloxane composition according to the present invention may further include curing inhibitor, phosphorus, fine powder of a polymethacrylate resin, a heat stabilizer, a dye, a pigment, a flame retardant, a solvent, etc.

In addition, the curable polysiloxane composition may further include a tackifier to increase adhesiveness.

The tackifier may include an epoxy silane such as glycidoxypropyltrimethoxy-silane, glycidoxypropylmethyldimethoxysilane, glycidoxypropyltriethoxysilane or glycidoxypropylmethyldiethoxysilane, 2-(3-triethoxysilylpropyl)maleic anhydride, N-(3-trimethoxysilylpropyl)urea, N-(3-triethoxysilylpropyl)urea, N-(trimethoxysilylmethyl)urea, N-(methyl-dimethoxysilylmethyl)urea, O-(methylcarbamatomethyl)methyldimethoxysilane, O-(methyl-carbamatomethyl)trimethoxysilane, O-(ethylcarbamatomethyl)methyl-diethoxysilane, O-(ethylcarbamatomethyl)triethoxysilane, 3-methacryloyloxypropyltrimethoxysilane, methacryloyloxymethyltrimethoxysilane, methacryloyloxymethylmethyldimethoxysilane, methacryloyloxymethyltriethoxysilane, methacryloyloxymethylmethyldiethoxysilane, 3-acryloyloxypropyltrimethoxysilane, acryloyloxymethyltrimethoxysilane, or acryloyloxy-methylmethyldimethoxysilane.

Based on the total weight of the curable polysiloxane composition, the content of the tackifier may be 0.1 % by weight to 10 % by weight, 0.1 % by weight to 5 % by weight, 0.1 % by weight to 3 % by weight, or 0.1 % by weight to 2 % by weight.

### Physical properties of curable polysiloxane composition

The curable polysiloxane composition may have a refractive index of 1.45 to 1.55 at a wavelength of 480 nm and a wavelength of 598 nm. The refractive index may be measured at a D-line (480 nm, 589 nm) wavelength of a cured product made of the curable polysiloxane composition or a pre-cured composition using an Abbe refractive index meter. Within this range, transparency and mechanical properties of a cured product made of the curable polysiloxane composition may be improved.

A cured product with a thickness of 1 mm made of the curable polysiloxane composition may have a light transmittance of 80% or more, 82% or more, 84% or more, 86% or more, 88% or more, or 90% or more. Within these ranges, when the cured product made of the curable polysiloxane composition is used as an LED encapsulant, light may be smoothly emitted from each light source.

The cured product with a thickness of 1 mm made of the curable polysiloxane composition may have a Shore D hardness of 20 to 40, 22 to 40, 24 to 40, 26 to 40, or 28 to 40. The Shore D hardness of the cured product may be measured with a D hardness tester after injecting the curable polysiloxane composition into a Teflon-coated mold having a width of 4 cm × a length of 5 cm × a thickness of 6 mm, curing at 190°C for 10 minutes, and then cooling at room temperature to prepare a cured product. Within these ranges, mechanical properties and thermal shock resistance of the cured product made of the curable polysiloxane composition may be improved.

### <Encapsulant>

An encapsulant according to the present invention includes a curable polysiloxane composition including (A) a branched polysiloxane compound having at least one Si-bonded alkenyl group and at least one Si-bonded aryl group per molecule and including a siloxane unit represented by R SiO_{3/2} (where R' is a substituted or unsubstituted monovalent hydrocarbon group), (B) a branched polysiloxane compound having at least one Si-bonded hydrogen and at least one Si-bonded aryl group per molecule and including a siloxane unit represented by R SiO_{3/2} (where R" is a substituted or unsubstituted monovalent hydrocarbon group), (C) a compound that promotes a reaction between the alkenyl group of the compound (A) and the hydrogen of the compound (B), and (D) an inorganic filler.

The components (A) to (D) of the curable polysiloxane composition may be the same as the above-described components (A) to (D).

The encapsulant may have a film shape or sheet shape obtained by curing the curable polysiloxane composition.

The encapsulant may be used as an encapsulant for a display or a semiconductor.

The encapsulant may be provided in the form of encapsulating, covering, or adhering a display optical device or a semiconductor optical device. The optical device may be a light emitting diode (LED).

Since the light emitting diode (LED) emits light from the upper, lower, left, and right sides of the optical element, it is not desirable for the encapsulant to absorb light, and the encapsulant should exhibit high light transmittance. In addition, since the light emitting diode (LED) requires stability against high temperature and mechanical shock, thermal stability and mechanical properties of the encapsulant are required. Accordingly, since the curable polysiloxane composition according to the present invention has high transparency, light transmittance and mechanical properties as described above, excellent light transmittance, thermal stability and mechanical properties may be realized when a cured product made of the curable polysiloxane composition is used as an encapsulant.

Hereinafter, the present invention is described in more detail based on Examples and Comparative Examples. However, the following Examples and Comparative Examples are only examples for explaining the present invention in more detail, and the present invention is not limited by the following Examples and Comparative Examples.

### Examples

A curable polysiloxane composition of each of Examples 1 to 6 and Comparative Examples 1 to 5 was prepared using the following components and compositions shown in Table 1.

Synthesis of component (a-1): A three-necked flask was charged with 1 kg of a mixed solvent obtained by mixing water and toluene in a weight ratio of 1:9. A monomer mixture, in which a molar ratio of vinyldimethylchlorosilane: dimethyldichlorosilane: phenyltrichlorosilane was 1:6:3, was added to the flask while maintaining the temperature at 23°C. Next, condensation polymerization was performed while refluxing at 60°C for 3 hours. Next, the flask was cooled to room temperature, and then a water (H₂0) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (a-1): (Me₂ViSiO_{1/2})_{0.11} (diMeSiO_{2/2})_{0.63} (PhSiO_{3/2})_{0.26}

Synthesis of component (a-2): A three-necked flask was charged with 1 kg of a mixed solvent obtained by mixing water and toluene in a weight ratio of 1:9. A monomer mixture, in which a molar ratio of vinyldimethylchlorosilane: methylphenyldichlorosilane: phenyltrichlorosilane was 2:3:5, was added to the flask while maintaining the temperature at 23°C. Next, condensation polymerization was performed while refluxing at 60°C for 3 hours. Next, the flask was cooled to room temperature, and then a water (H₂0) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (a-2): (Me₂ViSiO_{1/2})_{0.23} (MePhSiO_{2/2})_{0.32} (PhSiO_{3/2})_{0.45}

Synthesis of component (a-3): A three-necked flask was charged with 1 kg of a mixed solvent obtained by mixing water and toluene in a weight ratio of 1:9. A monomer mixture, in which a molar ratio of vinyldimethylchlorosilane: methylphenyldichlorosilane: phenyltrichlorosilane was 1:2:7, was added to the flask while maintaining the temperature at 23°C. Next, condensation polymerization was performed while refluxing at 90°C for 3 hours. Next, the flask was cooled to room temperature, and then a water (H₂0) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (a-3): (Me₂ViSiO_{1/2})_{0.11} (MePhSiO_{2/2})_{0.21} (PhSiO_{3/2})_{0.68}

Component (a-4): Straight-chain polysiloxane compound represented by the following average unit formula:
- Average unit formula of component (a-4): ViMe₂SiO (Me₂SiO)₂₀SiMe₂Vi

Synthesis of component (b-1): A three-necked flask was charged with 500 g of a mixed solvent obtained by mixing water and toluene in a weight ratio of 1:9. A monomer mixture, in which a molar ratio of dimethylchlorosilane: phenyltrichlorosilane: methyltrichlorosilane was 3.5:2.5:4, was added to the flask while maintaining the temperature at 23°C. Next, condensation polymerization was performed while refluxing at 30°C for 3 hours. Next, the flask was cooled to room temperature, and then a water (H₂0) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (b-1): (HMe₂SiO_{1/2})_{0.35} (MeSiO_{3/2})_{0.40} (PhSiO_{3/2})_{0.25}

Synthesis of component (b-2): A three-necked flask was charged with 500 g of a mixed solvent obtained by mixing water and toluene in a weight ratio of 1:9. A monomer mixture, in which a molar ratio of dimethylchlorosilane: phenyltrichlorosilane was 4.5:5.5, was added to the flask while maintaining the temperature at 23°C. Next, condensation polymerization was performed while refluxing at 30°C for 1 hour. Next, the flask was cooled to room temperature, and then a water (H₂0) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (b-2): (HMe₂SiO_{1/2})_{0.44} (PhSiO_{3/2})_{0.56}

Synthesis of component (b-3): A three-necked flask was charged with 500 g of a mixed solvent obtained by mixing water and toluene in a weight ratio of 1:9. A monomer mixture, in which a molar ratio of dimethylchlorosilane: phenyltrichlorosilane: methyltrichlorosilane was 2:1:7, was added to the flask while maintaining the temperature at 23°C. Next, condensation polymerization was performed while refluxing at 30°C for 3 hours. Next, the flask was cooled to room temperature, and then a water (H20) layer was removed to prepare a solution. The solution was dissolved in toluene. Next, the solution was washed with water to remove chlorine as a by-product. Next, the neutral solution was distilled under reduced pressure to remove toluene, and a branched polysiloxane compound represented by the following average unit formula was obtained:
- Average unit formula of component (b-3): (HMe₂SiO_{1/2})_{0.21} (MeSiO_{3/2})_{0.71} (PhSiO_{3/2})_{0.08}

Component (b-4): Straight-chain polysiloxane compound represented by the following average unit formula
- Average unit formula of component (b-4): HMe₂SiO (Ph₂SiO)SiMe₂H

Component (c-1): Compound represented by Chemical Formula 1-1 below:

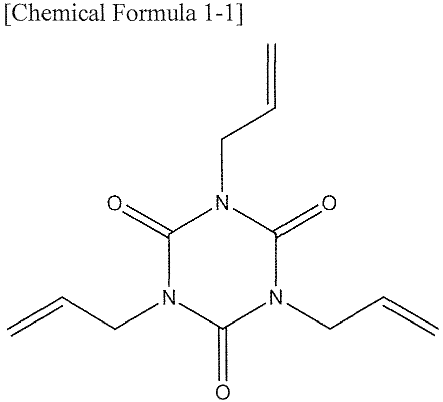

Component (c-2): Compound represented by Chemical Formula 2-1 below: 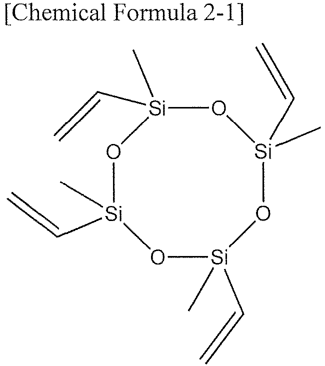
Component (d-1): Fumed silica (methanol value: 0, specific surface area: 150 m²/g)
Component (d-2): Fumed silica (methanol value: 75, specific surface area: 150 m²/g)
Component (e): Tackifier (GF 80, manufactured by GENIOSIL)
Component (f): Catalyst (Pt-CS 2.0, manufactured by Unicore)

### Experimental examples

### Experimental Example 1- Viscosity measurement

For the compositions of Examples 1 to 6 and Comparative Examples 1 to 5 before curing, the viscosity was measured at a shear rate of 10/s at 25°C in accordance with ISO 3219, and the results are shown in Table 1 below.

### Experimental Example 2 - Refractive index measurement

For the compositions of Examples 1 to 6 and Comparative Examples 1 to 5 before curing, the refractive index was measured at a D-line (480 nm, 589 nm) wavelength using an Abbe refractive index meter, and the results are shown in Table 1 below.

### Experimental Example 3 - Aggregated particle confirmation

Each of the compositions of Examples 1 to 6 and Comparative Examples 1 to 5 before curing was put onto a slide glass, and then compressed, and the generation of aggregated particles was visually observed through a microscope. The results are shown in Table 1 below.

### Experimental Example 4 - Dome lens shape confirmation

Each of the compositions of Examples 1 to 6 and Comparative Examples 1 to 5 before curing was dispensed on a PCB substrate in a dome lens shape with a size of about 2.5 mm using a jet dispense. A side surface of the dome lens of each of Examples 1 to 6 and Comparative Examples 1 to 5 was observed through a microscope and evaluated according to the following criteria. The results are shown in Table 1 below.
- ⊚: Having a height of 0.5 mm to 1 mm, Dome shape being not distorted or biased
- ∘: Having a height of 0.5 mm to 1 mm, Dome shape being distorted or biased
- X: Having a height of less than 0.5 mm, Dome shape being distorted or biased

### Experimental Example 5 - Hardness measurement

The composition of each of Examples 1 to 6 and Comparative Examples 1 to 5 was put into a Teflon-coated mold with a width of 4 cm × a length of 5 cm × a thickness of 6 mm and was cured at 190°C for 10 minutes and then cooled at room temperature. Next, the hardness of the cured products was measured with a Shore D hardness tester, and the results are shown in Table 1 below.

### Experimental Example 6 - Transparency evaluation

The transparency of the cured products manufactured in Experimental Example 5 was evaluated according to the following criteria, and the results are shown in Table 1 below.
- ⊚: The entire cured product is transparent when observed with the naked eye
- ∘: A portion of the cured material is opaque when observed with the naked eye
- X: The entire cured product is opaque when observed with the naked eye

### Experimental Example 7 - Surface smoothness evaluation

The surfaces of the cured products manufactured in Experimental Example 5 were visually observed using a microscope, and then evaluated according to the following criteria. The results are shown in Table 1 below.
- ∘: No wrinkles are observed on the surface of the cured product
- X: Wrinkles are observed on the surface of the cured product

### Experimental Example 8 - Transmittance measurement

The composition of each of Examples 1 to 6 and Comparative Examples 1 to 5 was put into a Teflon-coated mold having a width of 4 cm × a length of 5 cm × a thickness of 1 mm and cured at 190°C for 10 minutes, followed by cooling at room temperature. Next, a transmittance (based on a wavelength of 450 nm) of each of the cured products was measured with a Specord 200 Plus UV-Vis spectrometer, and the results are shown in Table 1 below.

### Experimental Example 9 - Heat shock evaluation

### Thermal Shock Evaluation

100 droplets of the composition of Example 1 were dispensed in the form of a dome lens with a size of about 2.5 mm on a PCB substrate using a jet dispense, and then thermally cured at 190°C for 10 minutes, followed by cooling at room temperature to prepare 100 dome lens shapes. In addition, 100 dome lenses were prepared from the composition of each of Examples 2 to 6 and Comparative Examples 1 to 5 in the same manner as in Example 1.

Exposing the dome lens for 15 minutes in each of a low-temperature (-45°C) chamber and a high-temperature (125°C) chamber was regarded as one cycle. After 200 cycles, it was confirmed whether the dome lens was peeled off on the PCB substrate. The heat shock was evaluated according to the following criteria, and the results are shown in Table 1 below.
- ⊚: No dome lens peeled off from the substrate
- ∘: No dome lens peeled off from the substrate, but there is a dome lens with a lifting phenomenon
- X: There is a dome lens peeled off from the substrate

### Experimental Example 10 - Adhesion force measurement

Each of the compositions of Examples 1 to 6 and Comparative Examples 1 to 5 was dispensed in the form of a dome lens with a size of about 2.5 mm on a PCB substrate using a jet dispense, and then thermally cured at 190°C for 10 minutes. Next, the adhesion force between the dome lens and the PCB substrate was measured under the following conditions using a die shear tester.
- Test speed: 700 µm/s
- Shear height: 30µm
- Test load: 400 g
- Maximum test load: 5,000 g

**[Table 1]**

| Classification | Unit | Example 1 | Example 2 | Example 3 | Example 4 | Example 5 | Example 6 | Comparative Example 1 | Comparative Example 2 | Comparative Example 3 | Comparative Example 4 | Comparative Example 5 |
|---|---|---|---|---|---|---|---|---|---|---|---|---|
| Component (a-1) | | 53 | - | - | - | - | 53 | - | 53 | - | 30 | - |
| Component (a-2) | | - | 53 | 53 | - | 53 | - | - | - | - | - | 59 |
| Component (a-3) | | - | - | - | 53 | - | - | - | - | - | - | - |
| Component (a-4) | | - | - | - | - | - | - | 53 | - | 59 | - | - |
| Component (b-1) | | 30 | - | - | 30 | 30 | - | 30 | - | - | 63 | - |
| Component (b-2) | % by weight | - | - | 30 | - | - | 30 | - | - | - | - | 30 |
| Component (b-3) | | - | 30 | - | - | - | - | - | - | - | - | - |
| Component (b-4) | | - | - | - | - | - | - | - | 30 | 20 | - | - |
| Component (c-1) | | 10 | - | 10 | - | 10 | - | 10 | - | 10 | - | - |
| Component (c-2) | | - | 10 | - | 10 | - | 10 | - | 10 | - | - | 10 |
| Component (d-1) | | - | - | - | - | 3 | 3 | - | - | - | - | - |
| Component (d-2) | | 6 | 6 | 6 | 6 | 3 | 3 | 6 | 6 | 10 | 6 | - |
| Component (e) | | 1 | 1 | 1 | 1 | 1 | 1 | 1 | 1 | 1 | 1 | 1 |
| Component (f) | ppm | 3 | 3 | 3 | 3 | 3 | 3 | 3 | 3 | 3 | 3 | 3 |
| Viscosity | mPa·s | 16000 | 18000 | 21000 | 15500 | 17000 | 16500 | 12500 | 13000 | 12500 | 15000 | 22000 |
| Refractive index (480 nm) | - | 1.46 | 1.48 | 1.50 | 1.51 | 1.51 | 1.52 | 1.44 | 1.44 | 1.41 | 1.44 | 1.53 |
| Refractive index (589nm) | - | 1.45 | 1.47 | 1.49 | 1.50 | 1.50 | 1.51 | 1.43 | 1.43 | 1.39 | 1.43 | 1.52 |
| Aggregated particles | - | Not generate d | Not generated | Not generate d | Not generate d | Not generate d | Not generate d | Not generated | Not generated | Not generated | Not generated | Not generated |
| Dome lens shape | - | ○ | ○ | ○ | ○ | ⊚ | ⊚ | ○ | ○ | ⊚ | ○ | X |
| Hardness | Shore D | 30 | 28 | 29 | 28 | 33 | 34 | 28 | 28 | 35 | 27 | 8 |
| Trans-parency | - | ⊚ | ⊚ | ⊚ | ⊚ | ⊚ | ⊚ | ○ | ○ | X | ○ | ⊚ |
| Surface smoothness | - | ○ | ○ | ○ | ○ | ○ | ○ | ○ | ○ | ○ | X | ○ |
| Transmittance | % | 86 | 91 | 91 | 91 | 91 | 92 | 75 | 75 | 49 | 76 | 93 |
| Thermal shock evaluation | - | ⊚ | ○ | ○ | ○ | ⊚ | ⊚ | ○ | ○ | ○ | X | X |
| Adhesion force | gf | 310 | 305 | 306 | 305 | 330 | 332 | 305 | 304 | 305 | 266 | 232 |

Referring to Table 1, it can be confirmed that Examples 1 to 6 exhibit excellent transparency, light transmittance, adhesiveness and mechanical properties.

It can be confirmed that, compared to Examples 1 to 6, Comparative Examples 1 and 2 exhibit decreased transparency, particularly significantly decreased light transmittance. In addition, it can be confirmed that, compared to Examples 1 to 6, Comparative Example 3 exhibits significantly decreased transparency and light transmittance.

It can be confirmed that, compared to Examples 1 to 6, Comparative Example 4 exhibits decreased transparency, thermal shock resistance and adhesion force and non-uniform surface properties.

It can be confirmed that, compared to Examples 1 to 6, Comparative Example 5 does not exhibit decreased transparency and light transmittance, but exhibits significantly decreased mechanical properties and thermal shock resistance.

In conclusion, it can be confirmed that when the cured products made of the compositions of Comparative Examples 1 to 5 are used as an encapsulant of a light emitting diode (LED), the durability of the encapsulant may be decreased or the encapsulant may absorb a large amount of light, so that product reliability may be decreased.

## Claims

1. A curable polysiloxane composition, comprising:
(A) a branched polysiloxane compound having at least one Si-bonded alkenyl group and at least one Si-bonded aryl group per molecule and comprising a siloxane unit represented by R SiO_{3/2} (where R' is a substituted or unsubstituted monovalent hydrocarbon group);
(B) a branched polysiloxane compound having at least one Si-bonded hydrogen and at least one Si-bonded aryl group per molecule and comprising a siloxane unit represented by R"SiO_{3/2} (where R" is a substituted or unsubstituted monovalent hydrocarbon group); and wherein the compound (B) is represented by Average Unit Formula 2 below:
[Average Unit Formula 2] (R⁷R⁸R⁹SiO_{1/2})ₑ (R¹⁰SiO_{3/2})_{f} (R¹¹SiO_{3/2})_{g}
where R⁷, R⁸ and R⁹ are each independently selected from a substituted or unsubstituted monovalent hydrocarbon group, at least one of R⁷, R⁸ and R⁹ is hydrogen, R¹⁰ is a substituted or unsubstituted monovalent hydrocarbon group, R¹¹ is an aryl group having 6 to 12 carbon atoms, 0 < e < 1, 0 ≤ f < 1, 0 < g < 1, and e + f + g = 1;
(C) a compound that promotes a reaction between the alkenyl group of the compound (A) and the hydrogen of the compound (B); and
(D) an inorganic filler, and
wherein the total weight of the curable polysiloxane composition, the content of the component (B) 10 % by weight to 50 % by weight,
wherein a molar ratio of the Si-bonded hydrogen in the component (B) to the Si-bonded alkenyl group in the component (A) 0.7 to 1.

2. The curable polysiloxane composition according to claim 1, wherein the compound (A) is represented by Average Unit Formula 3 below:
[Average Unit Formula 1] (R¹R²R³SiO_{1/2})ₐ (R⁴R⁵SiO_{2/2})_{b} (R⁶SiO_{3/2})_{c} (SiO_{4/2})_{d}
where R¹, R² and R³ are each independently selected from a substituted or unsubstituted monovalent hydrocarbon group, at least one of R¹, R² and R³ is an alkenyl group, R⁴ and R⁵ are each independently selected from a substituted or unsubstituted monovalent hydrocarbon group and an aryl group having 6 to 12 carbon atoms, R⁶ is an aryl group having 6 to 12 carbon atoms, 0< a< 1,0 < b < 1,0 < c < 1, 0 ≤ d < 1, and a + b + c + d = 1.

3. The curable polysiloxane composition according to claim 1, wherein the compound (C) comprises at least one of compounds represented by Chemical Formulas 1 and 2 below: 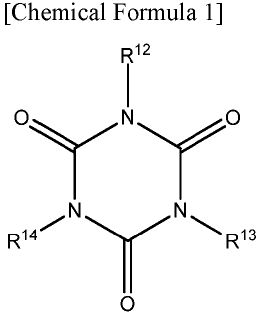 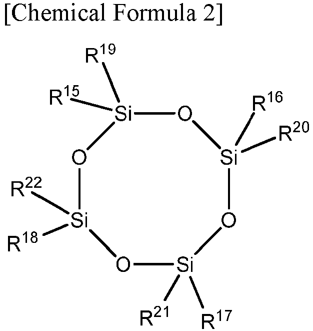
wherein, in Chemical Formula 1, R¹², R¹³ and R¹⁴ are each independently an alkenyl group having 2 to 20 carbon atoms, and
in Chemical Formula 2, R¹⁵, R¹⁶, R¹⁷ and R¹⁸ are each independently a substituted or unsubstituted monovalent hydrocarbon group, and R¹⁹, R²⁰, R²¹ and R²² are each independently an alkenyl group having 2 to 20 carbon atoms.

4. The curable polysiloxane composition according to claim 1, wherein the inorganic filler (D) is comprised in an amount of 0.1 parts by weight to 20 parts by weight with respect to 100 parts by weight of the curable polysiloxane composition.

5. The curable polysiloxane composition according to claim 1, wherein the inorganic filler (D) comprises fumed silica.

6. The curable polysiloxane composition according to claim 5, wherein the fumed silica comprises a first fumed silica having a methanol value of less than 15 and a second fumed silica having a methanol value determined in accordance with the method outlined in the description of greater than 40.

7. The curable polysiloxane composition according to claim 1, wherein the curable polysiloxane composition has a refractive index determined in accordance with the method outlined in the description of 1.45 to 1.55 at a wavelength of 480 nm and a wavelength of 598 nm.

8. The curable polysiloxane composition according to claim 1, wherein a cured product with a thickness of 1 mm made of the curability polysiloxane composition has a light transmittance determined in accordance with the method outlined in the description of 80% or more.

9. The curable polysiloxane composition according to claim 1, wherein the cured product with a thickness of 1 mm made of the curable polysiloxane composition has a Shore D hardness determined in accordance with the method outlined in the description of 20 to 40.

10. An encapsulant comprising a curable polysiloxane composition, the curable polysiloxane composition comprising:
(A) a branched polysiloxane compound having at least one Si-bonded alkenyl group and at least one Si-bonded aryl group per molecule and comprising a siloxane unit represented by R SiO_{3/2} (where R' is a substituted or unsubstituted monovalent hydrocarbon group);
(B) a branched polysiloxane compound having at least one Si-bonded hydrogen and at least one Si-bonded aryl group per molecule and comprising a siloxane unit represented by R"SiO_{3/2} (where R" is a substituted or unsubstituted monovalent hydrocarbon group); and wherein the compound (B) is represented by Average Unit Formula 2 below:
[Average Unit Formula 2] (R⁷R⁸R⁹SiO_{1/2})ₑ (R¹⁰SiO_{3/2})_{f} (R¹¹SiO_{3/2})_{g}
where R⁷, R⁸ and R⁹ are each independently selected from a substituted or unsubstituted monovalent hydrocarbon group, at least one of R⁷, R⁸ and R⁹ is hydrogen, R¹⁰ is a substituted or unsubstituted monovalent hydrocarbon group, R¹¹ is an aryl group having 6 to 12 carbon atoms, 0 < e < 1, 0 ≤ f < 1, 0 < g < 1, and e + f + g = 1;
(C) a compound that promotes a reaction between the alkenyl group of the compound (A) and the hydrogen of the compound (B); and
(D) an inorganic filler, and
wherein the total weight of the curable polysiloxane composition, the content of the component (B) 10 % by weight to 50 % by weight,
wherein a molar ratio of the Si-bonded hydrogen in the component (B) to the Si-bonded alkenyl group in the component (A) 0.7 to 1.

## Patentansprüche

1. Härtbare Polysiloxanzusammensetzung, umfassend:
(A) eine verzweigte Polysiloxanverbindung, die mindestens eine Si-gebundene Alkenylgruppe und mindestens eine Si-gebundene Arylgruppe pro Molekül aufweist und eine durch R'SiO_{3/2} wiedergegebene Siloxaneinheit umfasst (wobei R' für eine substituierte oder unsubstituierte einwertige Kohlenwasserstoffgruppe steht);
(B) eine verzweigte Polysiloxanverbindung, die mindestens einen Si-gebundenen Wasserstoff und mindestens eine Si-gebundene Arylgruppe pro Molekül aufweist und eine durch R"SiO_{3/2} wiedergegebene Siloxaneinheit umfasst (wobei R" für eine substituierte oder unsubstituierte einwertige Kohlenwasserstoffgruppe steht); und wobei die Verbindung (B) durch die nachstehende durchschnittliche Einheitsformel 2 wiedergegeben wird:
[Durchschnittliche Einheitsformel 2] (R⁷R⁸R⁹SiO_{1/2})ₑ (R¹⁰SiO_{3/2})_{f} (R¹¹SiO_{3/2})_{g}
wobei R⁷, R⁸ und R⁹ jeweils unabhängig aus einer substituierten oder unsubstituierten einwertigen Kohlenwasserstoffgruppe ausgewählt sind, mindestens eine der Variablen R⁷, R⁸ und R⁹ für Wasserstoff steht, R¹⁰ für eine substituierte oder unsubstituierte einwertige Kohlenwasserstoffgruppe steht, R¹¹ für eine Arylgruppe mit 6 bis 12 Kohlenstoffatomen steht, 0 < e < 1, 0 ≤ f < 1, 0 < g < 1 und e + f + g = 1;
(C) eine Verbindung, die eine Reaktion zwischen der Alkenylgruppe der Verbindung (A) und dem Wasserstoff der Verbindung (B) fördert; und
(D) einen anorganischen Füllstoff, und
wobei, bezogen auf das Gesamtgewicht der härtbaren Polysiloxanzusammensetzung, der Gehalt der Komponente (B) 10 Gew.-% bis 50 Gew.-% beträgt,
wobei das Molverhältnis von Si-gebundenem Wasserstoff in der Komponente (B) zu Si-gebundener Alkenylgruppe in der Komponente (A) 0,7 bis 1 beträgt.

2. Härtbare Polysiloxanzusammensetzung nach Anspruch 1, wobei die Verbindung (A) durch die nachstehende durchschnittliche Einheitsformel 3 wiedergegeben wird:
[Durchschnittliche Einheitsformel 1] (R¹R²R³SiO_{1/2})ₐ (R⁴R⁵SiO_{2/2})_{b} (R⁶SiO_{3/2})_{c} (SiO_{4/2})_{d}
wobei R¹, R² und R³ jeweils unabhängig aus einer substituierten oder unsubstituierten einwertigen Kohlenwasserstoffgruppe ausgewählt sind, mindestens eine der Variablen R¹, R² und R³ für eine Alkenylgruppe steht, R⁴ und R⁵ jeweils unabhängig aus einer substituierten oder unsubstituierten einwertigen Kohlenwasserstoffgruppe und einer Arylgruppe mit 6 bis 12 Kohlenstoffatomen ausgewählt sind, R⁶ für eine Arylgruppe mit 6 bis 12 Kohlenstoffatomen steht, 0 < a < 1, 0 < b < 1, 0 < c < 1, 0 ≤ d < 1 und a + b + c + d = 1.

3. Härtbare Polysiloxanzusammensetzung nach Anspruch 1, wobei die Verbindung (C) mindestens eine der durch die folgenden chemischen Formeln 1 und 2 wiedergegebenen Verbindungen umfasst: 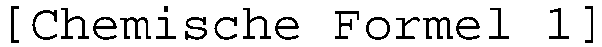 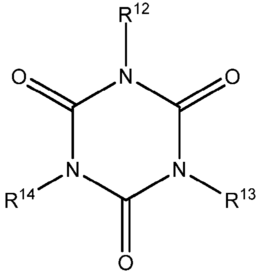 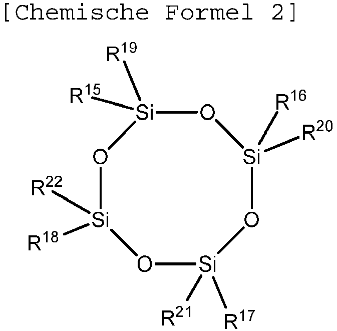
wobei in der Chemischen Formel 1 R¹², R¹³ und R¹⁴ jeweils unabhängig für eine Alkenylgruppe mit 2 bis 20 Kohlenstoffatomen stehen und
in der Chemischen Formel 2 R¹⁵, R¹⁶, R¹⁷ und R¹⁸ jeweils unabhängig für eine substituierte oder unsubstituierte einwertige Kohlenwasserstoffgruppe stehen und R¹⁹, R²⁰, R²¹ und R²² jeweils unabhängig für eine Alkenylgruppe mit 2 bis 20 Kohlenstoffatomen stehen.

4. Härtbare Polysiloxanzusammensetzung nach Anspruch 1, wobei der anorganische Füllstoff (D) in einer Menge von 0,1 Gewichtsteilen bis 20 Gewichtsteilen, bezogen auf 100 Gewichtsteile der härtbaren Polysiloxanzusammensetzung, enthalten ist.

5. Härtbare Polysiloxanzusammensetzung nach Anspruch 1, wobei der anorganische Füllstoff (D) pyrogene Kieselsäure umfasst.

6. Härtbare Polysiloxanzusammensetzung nach Anspruch 5, wobei die pyrogene Kieselsäure eine erste pyrogene Kieselsäure mit einer Methanolzahl von weniger als 15 und eine zweite pyrogene Kieselsäure mit einer gemäß der in der Beschreibung angegebenen Methode bestimmten Methanolzahl von mehr als 40 umfasst.

7. Härtbare Polysiloxanzusammensetzung nach Anspruch 1, wobei die härtbare Polysiloxanzusammensetzung einen gemäß der in der Beschreibung angegebenen Methode bestimmten Brechungsindex von 1,45 bis 1,55 bei einer Wellenlänge von 480 nm und einer Wellenlänge von 598 nm aufweist.

8. Härtbare Polysiloxanzusammensetzung nach Anspruch 1, wobei ein aus der härtbaren Polysiloxanzusammensetzung hergestelltes gehärtetes Produkt mit einer Dicke von 1 mm eine gemäß der in der Beschreibung angegebenen Methode bestimmte Lichtdurchlässigkeit von 80 % oder mehr aufweist.

9. Härtbare Polysiloxanzusammensetzung nach Anspruch 1, wobei das aus der härtbaren Polysiloxanzusammensetzung hergestellte gehärtete Produkt mit einer Dicke von 1 mm eine gemäß der in der Beschreibung angegebenen Methode bestimmte Shore-D-Härte von 20 bis 40 aufweist.

10. Vergussmasse, umfassend eine härtbare Polysiloxanzusammensetzung, wobei die härtbare Polysiloxanzusammensetzung Folgendes umfasst:
(A) eine verzweigte Polysiloxanverbindung, die mindestens eine Si-gebundene Alkenylgruppe und mindestens eine Si-gebundene Arylgruppe pro Molekül aufweist und eine durch R'SiO_{3/2} wiedergegebene Siloxaneinheit umfasst (wobei R' für eine substituierte oder unsubstituierte einwertige Kohlenwasserstoffgruppe steht);
(B) eine verzweigte Polysiloxanverbindung, die mindestens einen Si-gebundenen Wasserstoff und mindestens eine Si-gebundene Arylgruppe pro Molekül aufweist und eine durch R"SiO_{3/2} wiedergegebene Siloxaneinheit umfasst (wobei R" für eine substituierte oder unsubstituierte einwertige Kohlenwasserstoffgruppe steht); und wobei die Verbindung (B) durch die nachstehende durchschnittliche Einheitsformel 2 wiedergegeben wird:
[Durchschnittliche Einheitsformel 2] (R⁷R⁸R⁹SiO_{1/2})ₑ (R¹⁰SiO_{3/2})_{f} (R¹¹SiO_{3/2})_{g}
wobei R⁷, R⁸ und R⁹ jeweils unabhängig aus einer substituierten oder unsubstituierten einwertigen Kohlenwasserstoffgruppe ausgewählt sind, mindestens eine der Variablen R⁷, R⁸ und R⁹ für Wasserstoff steht, R¹⁰ für eine substituierte oder unsubstituierte einwertige Kohlenwasserstoffgruppe steht, R¹¹ für eine Arylgruppe mit 6 bis 12 Kohlenstoffatomen steht, 0 < e < 1, 0 ≤ f < 1, 0 < g < 1 und e + f + g = 1;
(C) eine Verbindung, die eine Reaktion zwischen der Alkenylgruppe der Verbindung (A) und dem Wasserstoff der Verbindung (B) fördert; und
(D) einen anorganischen Füllstoff, und
wobei, bezogen auf das Gesamtgewicht der härtbaren Polysiloxanzusammensetzung, der Gehalt der Komponente (B) 10 Gew.-% bis 50 Gew.-% beträgt,
wobei das Molverhältnis von Si-gebundenem Wasserstoff in der Komponente (B) zu Si-gebundener Alkenylgruppe in der Komponente (A) 0,7 bis 1 beträgt.

## Revendications

1. Composition de polysiloxane durcissable, comprenant :
(A) un composé polysiloxane ramifié ayant au moins un groupe alcényle lié à Si et au moins un groupe aryle lié à Si par molécule et comprenant un motif siloxane représenté par R'SiO_{3/2} (où R' est un groupe hydrocarboné monovalent substitué ou non substitué) ;
(B) un composé polysiloxane ramifié ayant au moins un hydrogène lié à Si et au moins un groupe aryle lié à Si par molécule et comprenant un motif siloxane représenté par R"SiO_{3/2} (où R" est un groupe hydrocarboné monovalent substitué ou non substitué) ; et le composé (B) étant représenté par la formule de motif moyenne 2 ci-dessous :
[formule de motif moyenne 2] (R⁷R⁸R⁹SiO_{1/2})ₑ (R¹⁰SiO_{3/2})_{f} (R¹¹SiO_{3/2})_{g}
R⁷, R⁸ et R⁹ étant chacun indépendamment choisis parmi un groupe monovalent hydrocarboné substitué ou non substitué, au moins l'un parmi R⁷, R⁸ et R⁹ étant hydrogène, R¹⁰ étant un groupe monovalent hydrocarboné substitué ou non substitué, R¹¹ étant un groupe aryle ayant 6 à 12 atomes de carbone, 0 < e < 1, 0 ≤ f < 1, 0 < g < 1, et e + f + g = 1 ;
(C) un composé qui favorise une réaction entre le groupe alcényle du composé (A) et l'hydrogène du composé (B) ; et
(D) une charge inorganique, et
dans laquelle par rapport au poids total de la composition de polysiloxane durcissable, la teneur du composant (B) est de 10 % en poids à 50 % en poids,
dans laquelle un rapport molaire de l'hydrogène lié à Si dans le composant (B) sur le groupe alcényle lié à Si dans le composant (A) est de 0,7 à 1.

2. Composition de polysiloxane durcissable selon la revendication 1, le composé (A) étant représenté par la formule de motif moyenne 3 ci-dessous :
[formule de motif moyenne 1] (R¹R²R³SiO_{1/2})ₐ (R⁴R⁵SiO_{2/2})_{b} (R⁶SiO_{3/2})_{c} (SiO_{4/2})_{d}
R¹, R² et R³ étant chacun indépendamment choisis parmi un groupe hydrocarboné monovalent substitué ou non substitué, au moins l'un parmi R¹, R² et R³ étant un groupe alcényle, R⁴ et R⁵ étant chacun choisis indépendamment parmi un groupe hydrocarboné monovalent substitué ou non substitué et un groupe aryle possédant 6 à 12 atomes de carbone, R⁶ étant un groupe aryle possédant 6 à 12 atomes de carbone, 0 < a < 1, 0 < b < 1, 0 < c < 1, 0 ≤ d < 1, et a + b + c + d = 1.

3. Composition de polysiloxane durcissable selon la revendication 1, le composé (C) comprenant au moins un des composés représentés par les formules chimiques 1 et 2 ci-dessous : 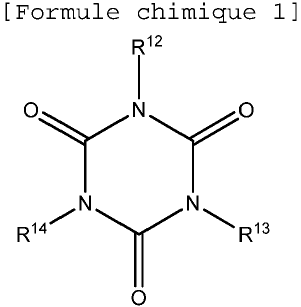 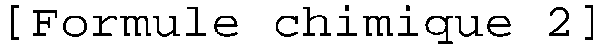 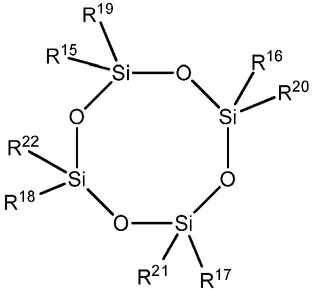
dans laquelle, dans la formule chimique 1, R¹², R¹³ et R¹⁴ sont chacun indépendamment un groupe alcényle ayant 2 à 20 atomes de carbone, et
dans la formule chimique 2, R¹⁵, R¹⁶, R¹⁷ et R¹⁸ sont chacun indépendamment un groupe hydrocarboné monovalent substitué ou non substitué, et R¹⁹, R²⁰, R²¹ et R²² sont chacun indépendamment un groupe alcényle ayant 2 à 20 atomes de carbone.

4. Composition de polysiloxane durcissable selon la revendication 1, dans laquelle la charge inorganique (D) est comprise en une quantité de 0,1 partie en poids à 20 parties en poids par rapport à 100 parties en poids de la composition de polysiloxane durcissable.

5. Composition de polysiloxane durcissable selon la revendication 1, dans laquelle la charge inorganique (D) comprend de la silice fumée.

6. Composition de polysiloxane durcissable selon la revendication 5, dans laquelle la silice fumée comprend une première silice fumée ayant un indice de méthanol inférieur à 15 et une seconde silice fumée ayant un indice de méthanol, déterminé selon le procédé décrit dans la description, supérieur à 40.

7. Composition de polysiloxane durcissable selon la revendication 1, dans laquelle la composition de polysiloxane durcissable a un indice de réfraction déterminé conformément au procédé décrit dans la description de 1,45 à 1,55 à une longueur d'onde de 480 nm et à une longueur d'onde de 598 nm.

8. Composition de polysiloxane durcissable selon la revendication 1, dans laquelle un produit durci ayant une épaisseur de 1 mm fait de la composition de polysiloxane durcissable a une transmittance de lumière, déterminée conformément au procédé décrit dans la description, de 80 % ou plus.

9. Composition de polysiloxane durcissable selon la revendication 1, dans laquelle le produit durci ayant une épaisseur de 1 mm fait de la composition de polysiloxane durcissable a une dureté Shore D déterminée conformément au procédé décrit dans la description de 20 à 40.

10. Agent d'encapsulation comprenant une composition de polysiloxane durcissable, la composition de polysiloxane durcissable comprenant :
(A) un composé polysiloxane ramifié ayant au moins un groupe alcényle lié à Si et au moins un groupe aryle lié à Si par molécule et comprenant un motif siloxane représenté par R'SiO_{3/2} (où R' est un groupe hydrocarboné monovalent substitué ou non substitué) ;
(B) un composé polysiloxane ramifié ayant au moins un hydrogène lié à Si et au moins un groupe aryle lié à Si par molécule et comprenant un motif siloxane représenté par R"SiO_{3/2} (où R" est un groupe hydrocarboné monovalent substitué ou non substitué) ; et le composé (B) étant représenté par la formule de motif moyenne 2 ci-dessous :
[formule de motif moyenne 2] (R⁷R⁸R⁹SiO_{1/2})ₑ (R¹⁰SiO_{3/2})_{f} (R¹¹SiO_{3/2})_{g}
R⁷, R⁸ et R⁹ étant chacun indépendamment choisis parmi un groupe monovalent hydrocarboné substitué ou non substitué, au moins l'un parmi R⁷, R⁸ et R⁹ étant hydrogène, R¹⁰ étant un groupe monovalent hydrocarboné substitué ou non substitué, R¹¹ étant un groupe aryle ayant 6 à 12 atomes de carbone, 0 < e < 1, 0 ≤ f < 1, 0 < g < 1, et e + f + g = 1 ;
(C) un composé qui favorise une réaction entre le groupe alcényle du composé (A) et l'hydrogène du composé (B) ; et
(D) une charge inorganique, et
dans laquelle par rapport au poids total de la composition de polysiloxane durcissable, la teneur du composant (B) est de 10 % en poids à 50 % en poids,
dans laquelle un rapport molaire de l'hydrogène lié à Si dans le composant (B) sur le groupe alcényle lié à Si dans le composant (A) est de 0,7 à 1.
